# EUROPEAN PATENT APPLICATION

(11) **EP 2 211 596 A1**
(43) Date of publication of application: **28.07.2010**
(21) Application number: 08835704.1
(22) Date of filing: 29.09.2008
(51) Int. Cl.: H05K 1/14, C09J 4/00, C09J 9/02, C09J 175/04, H01B 1/22, H01R 11/01, H05K 3/36

(54) **CIRCUIT-CONNECTING MATERIAL AND CIRCUIT TERMINAL CONNECTION STRUCTURE**

(30) Priority: 02.10.2007 JP 2007258637
(71) Applicant: Hitachi Chemical Company, Ltd., Tokyo 163-0449 (JP)
(72) Inventor: ARIFUKU, Motohiro, Chikusei-shi Ibaraki 308-8524 (JP); KOBAYASHI, Kouji, Chikusei-shi Ibaraki 308-8524 (JP); KOJIMA, Kazuyoshi, Chikusei-shi Ibaraki 308-8524 (JP); MOCHIZUKI, Nichiomi, Chikusei-shi Ibaraki 308-8524 (JP); KUDOU, Sunao, Chikusei-shi Ibaraki 308-8524 (JP)
(74) Representative: HOFFMANN EITLE
(86) International application number: PCT/JP2008/067661
(87) International publication number: WO 2009/044706

(57) **Abstract**

The circuit-connecting material of the invention is a circuit-connecting material for connection between a first circuit member having a first circuit electrode formed on the main side of a first board, and a second circuit member having a second circuit electrode formed on the main side of a second board, with the first circuit electrode and the second circuit electrode laid facing each other, the circuit-connecting material comprising a film-forming material, a curing agent that generates free radicals upon heating, a radical-polymerizing substance, an isocyanate group-containing compound and a ketimine group-containing compound represented by the following general formula (I), wherein the isocyanate group-containing compound content is 0.1-5 parts by weight and the ketimine group-containing compound content is 0.1-5 parts by weight with respect to 100 parts by weight as the total of the film-forming material and radical-polymerizing substance. 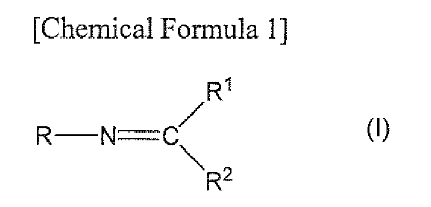 Wherein R represents an organic group, R¹ and R² each represent a C1-C4 monovalent aliphatic hydrocarbon group, and R¹ and R² may be linked together to form a cycloalkyl group.

## Description

### Technical Field

The present invention relates to a circuit-connecting material that, when it is situated between opposing circuit electrodes and the opposing circuit electrodes are pressed, accomplishes electrical connection between the electrodes in the pressing direction, as well as to a connection structure employing the circuit-connecting material and a method for producing the same.

### Background Art

Increasingly higher circuit densities in the field of precision electronic devices in recent years is leading to extremely narrow electrode widths and electrode spacings, thus potentially causing more loss, peeling and shifting of wirings. In order to solve this problem, electrical and electronic circuit-connecting materials with excellent low-temperature fast curing properties and longer usable life are being developed (see Patent document 1, for example).
[Patent document 1] Japanese Unexamined Patent Publication HEI No. 11-97825

### Disclosure of the Invention

### Problems to be Solved by the Invention

Even with conventional circuit-connecting materials, however, the bonding strength differs depending on the type of circuit material, and the target bonding strength sometimes cannot be obtained by bonding with circuit members whose surfaces are coated with or attached to one or more materials selected from among silicon nitride, silicone resins and polyimide resins.

The present invention has been accomplished in light of these circumstances, and its object is to provide a circuit-connecting material for electrical and electronic use, which exhibits especially satisfactory bonding strength for circuit members wherein the board supporting the circuit terminals is composed of at least one selected from among organic insulating materials and glass, and circuit members whose surfaces have been treated with at least one selected from among silicon nitride, silicone resins and polyimide resins, and which has a sufficient usable life, as well as a circuit terminal connection structure employing the circuit-connecting material.

### Means for Solving the Problems

In order to achieve the object stated above, the present inventors first studied the use of ketimine group-containing compounds and the use of isocyanate group-containing compounds. However, using ketimine group-containing compounds or isocyanate group-containing compounds alone has been problematic in that the usable life is extremely reduced in environments with a relative humidity of 70% or greater.

However it was found, surprisingly, that combining a ketimine group-containing compound and an isocyanate group-containing compound with specified structures in a specified mixing proportion can drastically improve the bonding strength for circuit members that have been surface-treated with silicon nitride or the like, even in environments with relative humidity of 70% or greater, so that a satisfactory usable life can be obtained. The present inventors have completed the invention based on this knowledge.

Specifically, the invention provides a circuit-connecting material for connection between a first circuit member having a first circuit electrode formed on the main side of a first board, and a second circuit member having a second circuit electrode formed on the main side of a second board, with the first circuit electrode and the second circuit electrode laid facing each other, the circuit-connecting material comprising a film-forming material, a curing agent that generates free radicals upon heating, a radical-polymerizing substance, an isocyanate group-containing compound and a ketimine group-containing compound represented by the following general formula (I), wherein the isocyanate group-containing compound content is 0.1-5 parts by weight and the ketimine group-containing compound content is 0.1-5 parts by weight with respect to 100 parts by weight as the total of the film-forming material and the radical-polymerizing substance. 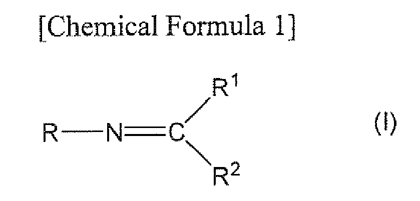 Wherein R represents an organic group, R¹ and R² each represent a C1-C4 monovalent aliphatic hydrocarbon group, and R¹ and R² may be linked together to form a cycloalkyl group.

The circuit-connecting material of the invention may further comprise an organic compound having a fluorine atom in the molecule.

The circuit-connecting material of the invention may further comprise an organic compound having a urethane group in the molecule and having a molecular weight of 10,000 or greater.

The circuit-connecting material of the invention may further comprise conductive particles.

The present invention further provides a circuit terminal connection structure comprising : a first circuit member having a first circuit electrode formed on the main side of a first board and a second circuit member having a second circuit electrode formed on the main side of a second board; wherein the first circuit electrode and the second circuit electrode are electrically connected by arranging the first circuit electrode and the second circuit electrode to face with each other, situating a circuit-connecting material of the invention between the first circuit electrode and the second circuit electrode, and hot pressing in that state.

In the circuit terminal connection structure of the invention, the surface of either or both the first circuit electrode and the second circuit electrode is preferably composed of at least one selected from among gold, silver, tin, platinum group and indium-tin oxide.

In addition, either or both the first board and the second board are preferably composed of at least one selected from among organic insulating materials and glass.

Also, the surface of either or both the first circuit member and the second circuit member is preferably subjected to coating or adhesion treatment with at least one selected from among silicon nitride, silicone compounds and polyimide resins.

### Effect of the Invention

According to the invention there are provided a circuit-connecting material for electrical and electronic use, which exhibits especially satisfactory bonding strength for circuit members wherein the board supporting the circuit terminals is composed of at least one selected from among organic insulating materials and glass, and circuit members whose surfaces have been treated with at least one selected from among silicon nitride, silicone resins and polyimide resins, and which has a sufficient usable life, as well as a circuit terminal connection structure employing the circuit-connecting material.

### Brief Description of the Drawings

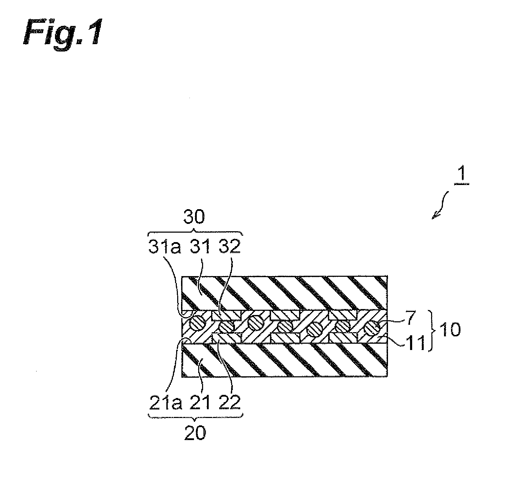

Fig. 1 is a schematic cross-sectional view showing an embodiment of a circuit terminal connection structure.

### Explanation of Symbols

1: Connection structure, 7: conductive particle, 10: adhesive layer, 11: insulating layer, 20: first circuit member, 21: first circuit board, 22: first connecting terminal, 30: second circuit member, 31: second circuit board, 32: second connecting terminal.

### Best Mode for Carrying Out the Invention

Preferred embodiments of the invention will now be described in detail.

The circuit-connecting material of the invention comprises a film-forming material, a curing agent that generates free radicals by heating, a radical-polymerizing substance, an isocyanate group-containing compound, and a ketimine group-containing compound represented by general formula (I) below.

The film-forming material in the circuit-connecting material of the invention may be polyvinyl formal, polystyrene, polyvinyl butyral, polyester, polyesterpolyurethane, polyamide, xylene resin, phenoxy resin, polyurethane resin or the like. The film-forming material may be modified by radical-polymerizing functional groups.

The curing agent that generates free radicals by heating (hereinafter also referred to as "free radical generator") in the circuit-connecting material of the invention may be a peroxide compound, azo-based compound or the like. These curing agents decompose by heat to generate free radicals, and they may be appropriately selected according to the target connection temperature, connection time and pot life, but from the viewpoint of high reactivity and pot life there are preferred organic peroxides with a 10-hour half-life temperature of 40°C or higher and a 1-minute half-life temperature of 180°C or lower, and more preferably organic peroxides with a 10-hour half-life temperature of 60°C or higher and a 1-minute half-life temperature of 170°C or lower. If the connection time is up to 25 seconds, the curing agent content is preferably 2.0-10 % by weight and more preferably 4.0-8.0 % by weight based on the total weight of the circuit-connecting material, in order to obtain a sufficient reaction rate. The curing agent content is preferably 0.05-20 parts by weight and more preferably 0.1-10 parts by weight with respect to 100 parts by weight as the total of the film-forming material and radical-polymerizing substance.

As preferred curing agents there may be mentioned diacyl peroxides, peroxy dicarbonates, peroxyester peroxyketals, dialkyl peroxides, hydroperoxides and silyl peroxides. In order to inhibit corrosion of the connecting terminals of the circuit member, the curing agent preferably contains a chloride ion or organic acid whose concentration are not greater than 5000 ppm, and more preferably the content of organic acids generated after thermal decomposition is low. Specifically, it is selected from among peroxy esters, dialkyl peroxides, hydroperoxides and silyl peroxides, and it is preferably selected from among peroxy esters with high reactivity. These curing agents may also be used in appropriate mixtures.

As peroxy esters there may be used cumylperoxy neodecanoate, 1,1,3,3-tetramethylbutylperoxy neodecanoate, 1-cyclahexyl-1-methylethylperoxy neodecanoate, t-hexylperoxy neodecanoate, t-butylperoxy pivalate, 1,1,3,3-tetramethylbutylperoxy-2-ethyl hexanonate, 2,5-dimethyl-2,5-di(2-ethylhexanoylperoxy)hexane, 1-cyclohexyl-1-methylethylperoxy2-ethyl hexanonate, t-hexylperoxy-2-ethyl hexanonate, t-butylperoxy-2-ethyl hexanonate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethyl-2,5-di(m-toluoylperoxy)hexane, t-butylperoxyisopropyl monocarbonate, t-butylperoxy-2-ethylhexyl monocarbonate, t-hexylperoxybenzoate, t-butylperoxy acetate and the like.

As dialkyl peroxides there may be used α,α'-bis(t-butylperoxy)diisopropylbenzene, dicumyl peroxide, 2,5-dimethyl-2,5-di(t-butylperoxy)hexane and t-butylcumyl peroxide.

As hydroperoxides there may be used diisopropylbenzene hydroperoxide and cumene hydroperoxide.

As diacyl peroxides there may be used isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As peroxy dicarbonates there may be used di-n-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy)dicarbonate, dimethoxybutylperoxy dicarbonate and di(3-methyl-3-methoxybutylperoxy)dicarbonate.

As peroxy ketals there may be used 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyclododecane and 2,2-bis(t-butylperoxy)decane.

As silyl peroxides there may be used t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide.

These curing agents (free radical generators) may be used alone or in combinations of two or more, and may also be used in admixture with triggers or inhibitors of decomposition. From the viewpoint of extending the usable life, these curing agents are preferably used in a microencapsulated form by coating with a polyurethane-based or polyester-based high molecular compound.

The (2) radical-polymerizing substance is a substance that has a functional group that polymerizes by radicals, and there may be mentioned acrylates, methacrylates and maleimide compounds. The radical-polymerizing substance may be used as a monomer or oligomer, or a monomer and oligomer may be used in combination.

As specific examples of acrylate (methacrylate) compounds there may be mentioned methyl acrylate, ethyl acrylate, isopropyl acrylate, isobutyl acrylate, ethyleneglycol diacrylate, diethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, tris(acryloyloxyethyl) isocyanurate, urethane acrylate and the like. These may be used alone or in combinations, and if necessary polymerization inhibitors such as hydroquinone or methyl ether hydroquinones may be used as appropriate. They preferably have dicyclopentenyl and/or tricyclodecanyl and/or triazine rings for improved heat resistance.

As maleimide compounds there may be mentioned compounds with two or more maleimide groups in the molecule, such as 1-methyl-2,4-bismaleimidebenzene, N,N'-m-phenylenebismaleimide, N,N'-p-phenylenebismaleimide, N,N'-m-toluilenebismaleimide, N,N'-4,4-biphenylenebismaleimide, N,N'-4,4-(3,3'-dimethylbiphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-3,3'-diphenylsulfonebismaleimide, N,N'-4,4-diphenyl etherbismaleimide, 2,2-bis(4-(4-maleimidephenoxy)phenyl)propane, 2,2-bis(3-s-butyl-4-8-(4-maleimidephenoxy)phenyl)propane, 1,1-bis(4-(4-maleimidephenoxy)phenyl)decane, 4,4'-cyclohexylidene-bis(1-(4-maleimidephenoxy)-2-cyclohexylbenzene and 2,2-bis(4-(4-maleimidephenoxy)phenyl)hexafluoropropane. These may be used alone or in combinations.

Using a radical-polymerizing substance having the phosphoric acid ester structure represented by the following formula (II) in combination with the radical-polymerizing substance is preferred to improve the bonding strength at the surface of inorganic materials such as metals. 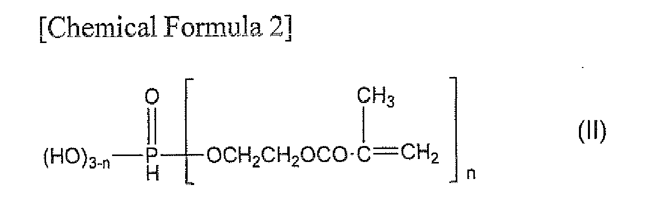 Wherein n represents an integer of 1-3.

The radical-polymerizing substance with a phosphoric acid ester structure is obtained as the reaction product of phosphoric anhydride and 2-hydroxyethyl (meth)acrylate. Specifically, this includes mono(2-methacryloyloxyethyl)acid phosphate and di(2-methacryloyloxyethyl)acid phosphate. These may be used alone or in combinations.

The radical-polymerizing substance content is preferably 0.01-50 parts by weight and more preferably 0.5-5 parts by weight with respect to 100 parts by weight as the total of the film-forming material and radical-polymerizing substance.

The isocyanate group-containing compound used for the invention is a compound containing an isocyanate group in the molecule. As isocyanate group-containing compounds there may be used monoisocyanate compounds such as p-toluenesulfonyl isocyanate, p-octadecylmonoisocyanate and methacryloyl isocyanate; diisocyanate compounds such as 2,4-tolylene diisocyanate, 2,6-tolylene diisocyanate, xylylene diisocyanate, hexamethylene diisocyanate, isophorone diisocyanate, diphenylmethane-4,4-diisocyanate, CORONATE L, MIRIONATE MR, CORONATE EH and CORONATE HL (the latter four are products of Nippon Polyurethane Industry Co., Ltd.); and terminal isocyanate group-containing compounds obtained by reaction between various polyether polyols, polyester polyols and polyamides with isocyanate compounds.

The isocyanate group-containing compound preferably has highly reactive polar groups such as hydroxyl group, nitrile group or carbonyl group at the ends in order to improve the bonding strength for adherend materials, and more preferably it has alkoxysilyl groups represented by -Si(OMe)₃ or -Si(OEt)₃ (where Me is methyl and Et is ethyl), in order to form chemical bonds between the adherend material surface and adsorbed water for firm bonding.

The isocyanate group-containing compound content is preferably 0.1-5 parts by weight and more preferably 0.5-3 parts by weight with respect to 100 parts by weight as the total of the film-forming material and the radical-polymerizing substance. If the content is less than 0.1 part by weight the desired effect will not be obtained, and if it exceeds 5 parts by weight the usable life will be shortened.

The ketimine group-containing compound used for the invention is represented by the following general formula (I).

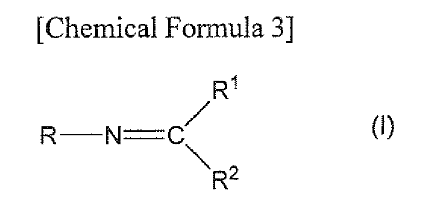

In general formula (I), the organic group represented by R is not particularly restricted and may be a saturated aliphatic group, an unsaturated aliphatic group, an aromatic group or an organic group composed of two or more of these groups. R preferably has highly reactive polar groups such as hydroxyl group, nitrile group or carbonyl group at the ends in order to improve the bonding strength for adherend materials, and more preferably it has silanol groups represented by - Si(OMe)₃ or -Si(OEt)₃, in order to form chemical bonds between the adherend material surface and adsorbed water for firm bonding.

Also general formula (I), R¹ and R² each represent a C1-C4 monovalent aliphatic hydrocarbon group, and R¹ and R² may be linked together to form a cycloalkyl group.

The ketimine group-containing compound represented by general formula (I) can be obtained by thermal reaction of a large excess of a carbonyl compound represented by the following general formula (III) and a compound with a primary amine represented by the following general formula (IV) at 80-170°C, followed by azeotropic distillation of the water and carbonyl compound produced during the reaction and the reaction solvent.

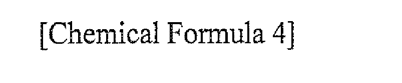

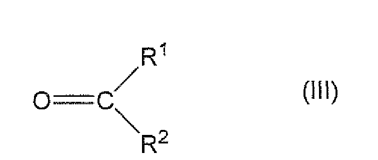

[Chemical Formula 5] R-NH₂ (IV)

Wherein R represents an organic group, R¹ and R² each represent a C1-C4 monovalent aliphatic hydrocarbon group, and R¹ and R² may be linked together to form a cycloalkyl group.

The content of the ketimine group-containing compound used for the invention is preferably 0.1-5 parts by weight and more preferably 0.5-3 parts by weight with respect to 100 parts by weight as the total of the film-forming material and the radical-polymerizing substance. If the content is less than 0.1 part by weight the desired effect will not be obtained, and if it exceeds 5 parts by weight the usable life will be shortened.

The circuit-connecting material of the invention may consist entirely of a film-forming material, a curing agent that generates free radicals by heating, a radical-polymerizing substance, an isocyanate group-containing compound, and a ketimine group-containing compound represented by the following general formula (I), but if necessary it may further contain the different components mentioned below.

The circuit-connecting material of the invention may further contain allyl (meth)acrylate. The allyl (meth)acrylate content is preferably 0.1-10 parts by weight and more preferably 0.5-5 parts by weight with respect to 100 parts by weight as the total of the film-forming material and the radical-polymerizing substance.

The circuit-connecting material of the invention may still further contain rubber fine particles in order to further improve the adhesion for the circuits to be connected. There are no particular restrictions on the material or the form of the rubber fine particles, and the material of the rubber fine particles may be silicone, acrylic emulsion, SBR, NBR, MBS or polybutadiene rubber fine particles, either alone or in combinations of two or more. Three-dimensionally crosslinked rubber fine particles are preferred for improved solvent resistance and easier dispersion of the fine particles in the adhesive. When the circuit-connecting material contains conductive particles as described below, the mean particle diameter of the rubber fine particles is preferably not greater than twice the mean particle diameter of the conductive particles to be added, and the elastic modulus at room temperature is preferably not greater than half the elastic modulus of the conductive particles and adhesive at room temperature.

In the circuit-connecting material of the invention a polymer or copolymer composed of at least one monomer component selected from among acrylic acid, acrylic acid esters, methacrylic acid esters and acrylonitrile, preferably in combination with glycidyl ether group-containing glycidyl acrylates or glycidyl methacrylate-containing copolymer-based acrylic rubber may be used, in order to obtain excellent stress relaxation. The (weight-average) molecular weight of the acrylic rubber is preferably at least 200,000 from the viewpoint of increasing the cohesion of the adhesive.

It may further contain a filler, softening agent, accelerator, age inhibitor, coloring agent, flame retardant, thixotropic agent, coupling agent, phenol resin or melamine resin.

A filler is preferably contained to improve the connection reliability. Any filler with a maximum diameter of less than the particle size of the conductive particles may be used, and it is preferably in the range of 5-60 parts by volume (with respect to 100 parts by volume of the adhesive resin component). A content of greater than 60 parts by volume may saturate the effect of improved reliability, while a content of less than 5 parts by volume will result in a reduced effect of addition.
Preferred coupling agents, from the viewpoint of improving adhesion, are compounds containing one or more groups selected from among vinyl, acrylic and epoxy groups.

The circuit-connecting material of the invention can provide connection by direct contact between opposing circuit electrodes during connection without including conductive particles, but more stable connection can be obtained if conductive particles are included.

The Conductive particles include metallic particles such as Au, Ag, Ni, Cu or solder, or carbon particles. Au is particularly preferred to obtain low connection resistance. The surface of a transition metal such as Ni may also be coated with a precious metal such as Au. The conductive particle surface preferably has protrusions with heights of between 50 nm and 500 nm at a pitch of up to 1 µm and with conductive metal surfaces, in order to increase the removability of the circuit-connecting material resin between the circuit electrodes to be connected. In addition, preferably the conductive layer is formed on nonconductive glass, ceramic or plastic by coating or the like so that a precious metal is the outermost layer, or heat-fusible metallic particles are used, because this will allow deformability by hot pressing and thereby increase the contact area between electrodes during connection and improve the reliability. The thickness of a precious metal covering layer is preferably at least 100 angstroms to obtain satisfactory resistance. However, when a precious metal layer is provided on a transition metal such as Ni, the thickness is preferably at least 300 angstroms because free radicals are generated by oxidation-reduction action due to simple loss of the precious metal layer, or loss of the precious metal layer occurring when the conductive particles are mixed and dispersed, thus leading to a shortened storage life. The conductive particles may be used in a range of 0.1-30 parts by volume with respect to 100 parts by volume of the adhesive resin component, according to the purpose of use. From the viewpoint of preventing shorting between adjacent circuits by excess conductive particles, the content is more preferably 0.1-10 parts by volume.

Also, the pot life is improved if the circuit-connecting material is divided into two or more layers including a layer containing a curing agent that generates free radicals and a layer comprising conductive particles.

The circuit-connecting material of the invention may be used for electrical connection and bonding between the bump electrodes of an IC chip and a chip-mounting board electrode, or as an adhesive for bonding between electrical circuits. The circuit-connecting material may be a liquid or film-like adhesive.

The circuit terminal connection structure of the invention and a method for producing it will now be explained.

Fig. 1 is a simplified cross-sectional view showing an embodiment of a circuit terminal connection structure. The connection structure 1 shown in Fig. 1 comprises a first circuit member 20 having a first circuit board 21 and a first circuit electrode (first connecting terminal) 22 formed on the main side 21a thereof, a second circuit member 30 having a second circuit board 31 and a second circuit electrode (second connecting terminal) 32 formed on the main side 31a thereof, and an adhesive layer 10 situated between and bonding the first circuit member 20 and the second circuit member 30. The second circuit member 30 is laid facing the first circuit member 20 so that the second circuit electrode 32 opposes the first circuit electrode 22.

The adhesive layer 10 is formed by arranging the circuit-connecting material of the invention between the first circuit member 20 and the second circuit member 30 and hot pressing them in that state. This embodiment is an example where a conductive circuit-connecting material is used to form the adhesive layer 10, and the adhesive layer 10 comprises an insulating layer 11 and conductive particles 7 dispersed in the insulating layer 11. The insulating layer 11 is a cured body formed by radical polymerization of the radical polymerizing compound, in the components of the adhesive other than the conductive particles.

The opposing first circuit electrode 22 and second circuit electrode 32 are electrically connected via the conductive particles 7. The first circuit electrodes 22 and the second circuit electrodes 32 formed on the same circuit board are insulated from each other.

For the first circuit board 31 and the second circuit board 21 there may be mentioned chip parts such as semiconductor chips, resistor chips and condenser chips, and boards such as printed boards. The circuit member will normally be provided with a plurality of connecting terminals, but it may have only one connecting terminal depending on the case.

More specifically, there may be used an inorganic material board made of a semiconductor, glass or ceramic, a plastic board, or a glass/epoxy board. As plastic boards there may be mentioned polyimide films, polycarbonate films and polyester films. The first circuit electrode and the second circuit electrode are formed of a metal such as copper. For more satisfactory electrical connection, the surfaces of either or both the first circuit electrode and the second circuit electrode are preferably a metal selected from among gold, silver, tin and platinum group. The surface layer may be selected from among silver, platinum metals or tin, or combinations thereof. A plurality of metals such as copper/nickel/gold may also be combined in a multilayer structure.

Also, either the first circuit member 20 or second circuit member 30 may be a liquid crystal display panel having a glass panel or plastic panel as the circuit board and having connecting terminals formed from ITO or the like. In addition, either the first circuit member 20 or second circuit member 30 may be a flexible printed circuit board (FPC), tape carrier package (TCP) or chip-on-film (COF) having a polyimide film as the circuit board, or a semiconductor silicon chip having a semiconductor board as the circuit board. These circuit members may be appropriately combined as necessary to form the connection structure.

The board on which the circuit electrode has been formed is preferably subjected to pre-heating treatment before the step of connecting to the circuit-connecting material, in order to avoid the effects of the volatilizing components on connection due to heating for the connecting.

The connection structure 1 is formed, for example, by superposing the first circuit member 20, film-like adhesive and the second circuit member 30 in that order with the first connecting terminal 22 and the second connecting terminal 32 opposing each other, and pressing them in that state, optionally with heating. The pressure is not particularly restricted so long as it is in a range that does not damage the adherend, and for most purposes it is preferably 0.1-10 MPa. The heating temperature is not particularly restricted but is preferably 100-250°C. The pressing and heating are preferably carried out for a period in a range of 0.5-120 seconds, and the bonding may include heating at 140-200°C, 3 MPa for 10 seconds.

In the circuit-connecting material of the invention, the adhesive that has flowed as a melt during connection to connect the opposing circuit electrodes is cured to maintain connection, and therefore the flow property of the adhesive is an important factor. When a 15 mm × 15 mm glass with a thickness of 0.7 mm is used and a 5 mm × 5 mm circuit connecting material with a thickness of 35 µm is sandwiched between the glass, with hot pressing being carried out at 150°C, 2 MPa for 10 seconds, the value of the flow property (B)/(A), wherein (A) is the initial area and (B) is the area after hot pressing, is preferably 1.3-3.0 and more preferably 1.5-2.5. A value of less than 1.3 is a poor flow property which may not result in satisfactory connection, while a value of greater than 3.0 will tend to result in air bubble generation and inferior reliability.

The 40°C elastic modulus after curing of the circuit-connecting material of the invention is preferably 100-3000 MPa and more preferably 300-2000 MPa.

In the method of connecting the circuit terminals according to the invention, the circuit-connecting material of the invention may be formed on one electrode circuit having the surface composed of at least one selected from among gold, silver, tin, platinum group and indium-tin oxide (ITO), and then another circuit electrode positioned thereover and heated and pressed therewith for connection.

According to the invention it is possible to provide a circuit-connecting material for electrical and electronic use, which exhibits especially satisfactory bonding strength between circuit members wherein the board supporting the circuit terminals is composed of at least one selected from among organic insulating materials such as polyimide resins, and glass, and circuit members whose surfaces have been coated with or attached to at least one selected from among silicon nitride, silicone resins and polyimide resins, and which has a sufficient usable life.

### Examples

The present invention will now be explained in greater detail based on examples and comparative examples, with the understanding that these examples are in no way limitative on the invention.

### (Synthesis of urethane acrylate)

There were combined 400 parts by weight of polycaprolactonediol with a weight-average molecular weight of 800, 131 parts by weight of 2-hydroxypropyl acrylate, 0.5 part by weight of dibutyltin dilaurate as a catalyst and 1.0 part by weight of hydroquinonemonomethyl ether as a polymerization inhibitor, while stirring and heating at 50°C. Next, 222 parts by weight of isophorone diisocyanate was added dropwise and the temperature was raised to 80°C while stirring for urethanation reaction. Upon confirming at least a 99% isocyanate group reaction rate, the reaction temperature was lowered to obtain urethane acrylate.

### (Preparation of polyester-urethane resin)

A polyester-urethane resin was prepared using terephthalic acid as a dicarboxylic acid, propylene glycol as a diol and 4,4'-diphenylmethane diisocyanate as an isocyanate, with a terephthalic acid/propylene glycol/4,4'-diphenylmethane diisocyanate molar ratio of 1.0/1.3/0.25. The obtained polyester-urethane resin was dissolved in methyl ethyl ketone to 20 % by weight.

### (Synthesis of ketimine group-containing compound (A-1))

After adding 130 g of hexamethylenediamine dropwise to 300 g of methyl ethyl ketone that had been stirred at 300 rpm at a temperature of 60°C, and conducting continuous reaction for 7 hours while stirring, the low-boiling-point components were removed under reduced pressure at 90°C to obtain a ketimine group-containing compound (A-1) as a pale yellow clear liquid.

### (Synthesis of ketimine group-containing compound (A-2))

After adding 268.5 g of γ-aminopropyltrimethoxysilane dropwise to 300 g of methyl ethyl ketone that had been stirred at 300 rpm at a temperature of 60°C, and conducting continuous reaction for 7 hours while stirring, the low-boiling-point components were removed under reduced pressure at 90°C to obtain a ketimine group-containing compound (A-2) as a pale yellow clear liquid.

### (Formation of conductive particles)

A nickel layer with a thickness of 0.2 µm was formed on the surface of particles having polystyrene nuclei, and then a gold layer was formed on the outside of the nickel layer to a thickness of 0.04 µm to produce conductive particles with a mean particle size of 10 µm.

### [Example 1]

After combining 40 g of urethane acrylate, 60 g of a polyester-urethane resin, 1 g of a phosphoric acid ester-type acrylate (trade name: P2M by Kyoeisha Yushi Kagaku Kogyo Co., Ltd.), 0.5 g of hexamethylene diisocyanate as an isocyanate group-containing compound, 0.5 g of the ketimine group-containing compound (A-1) and 5 g of t-hexylperoxy2-ethyl hexanonate as a free radical generator by solid weight, 3 % by volume conductive particles were further added and dispersed therein to obtain a liquid circuit-connecting material 1.

### [Example 2]

Circuit-connecting material 2 was obtained in the same manner as Example 1, except that γ-isocyanatopropyltriethoxysilane was used instead of hexamethylene diisocyanate as the isocyanate group-containing compound.

### [Example 3]

Circuit-connecting material 3 was obtained in the same manner as Example 1, except that ketimine group-containing compound (A-2) was used instead of ketimine group-containing compound (A-1).

### [Example 4]

Circuit-connecting material 4 was obtained in the same manner as Example 2, except that ketimine group-containing compound (A-2) was used instead of ketimine group-containing compound (A-1).

### [Example 5]

Circuit-connecting material 5 was obtained in the same manner as Example 2, except that the amount of γ-isocyanatopropyltriethoxysilane used was 0.1 g.

### [Example 6]

Circuit-connecting material 6 was obtained in the same manner as Example 2, except that the amount of ketimine group-containing compound (A-2) used was 0.1 g.

### [Example 7]

Circuit-connecting material 7 was obtained in the same manner as Example 6, except that the amount of γ-isocyanatopropyltriethoxysilane used was 0.1 g.

### [Example 8]

Circuit-connecting material 8 was obtained in the same manner as Example 2, except that the amount of γ-isocyanatopropyltriethoxysilane used was 5 g.

### [Example 9]

Circuit-connecting material 9 was obtained in the same manner as Example 2, except that the amount of ketimine group-containing compound (A-2) used was 5 g.

### [Example 10]

Circuit-connecting material 10 was obtained in the same manner as Example 9, except that the amount of γ-isocyanatopropyltriethoxysilane used was 5 g.

### [Example 11]

There was dissolved 50 g of a phenoxy resin (trade name: PKHC by Union Carbide Corp., average molecular weight: 45,000) in a mixed solvent comprising toluene (boiling point of 110.6°C, SP value: 8.90)/ethyl acetate (boiling point of 77.1 °C, SP value: 9.10) at 50/50 by weight ratio, to produce a solution with a solid content of 40%. Circuit-connecting material 11 was obtained in the same manner as Example 4, except for using the obtained phenoxy resin solution instead of the polyester-urethane resin solution.

### [Example 12]

### (Preparation of fluorine-containing polyimide resin)

After adding 15.0 mmol of polyoxypropylenediamine as a diamine compound, 105.0 mmol of 2,2-bis[4-(4-aminophenoxy)phenyl]hexafluoropropane and 287 g of N-methyl-2-pyrrolidone as an aprotic polar solvent to a 1000 mL separable flask equipped with a Dean-Stark reflux condenser, thermometer and stirrer, the mixture was stirred for 30 minutes at room temperature.
Upon completion of stirring, there were added 180 g of toluene as an aromatic hydrocarbon azeotropically distillable with water and 114.0 mmol of 4,4'-hexafluoropropylidenebisphthalic dianhydride as a tetracarboxylic dianhydride, and the mixture was heated to a temperature of 50°C and stirred, after which the temperature was raised to 160°C for 3 hours of reflux. After a stoichiometric amount of water had accumulated in the water measuring receptacle and no further run-off of water was observed, the water and toluene in the water measuring receptacle were removed and the temperature was increased to 180°C for removal of the toluene in the reaction mixture, to obtain an NMP solution of a polyimide resin.
The NMP solution of the polyimide resin was reprecipitated with methanol, pulverized and dried to obtain a fluorine-modified polyimide resin containing no silicon atoms in the molecule.
The fluorine-modified polyimide resin was dissolved in methyl ethyl ketone to 40% % by weight.
Circuit-connecting material 12 was obtained in the same manner as Example 4, except that 55 g of polyester-urethane resin above and 5 g of fluorine-modified polyimide resin were used, by solid weight ratio.

### [Comparative Example 1]

Circuit-connecting material 13 was obtained in the same manner as Example 1, except that hexamethylene diisocyanate and ketimine compound (A-1) were not used.

### [Comparative Example 2]

Circuit-connecting material 14 was obtained in the same manner as Example 4, except that the amount of γ-isocyanatopropyltriethoxysilane used was 0.05 g.

### [Comparative Example 3]

Circuit-connecting material 15 was obtained in the same manner as Example 4, except that the amount of ketimine group-containing compound (A-2) used was 0.05 g.

### [Comparative Example 4]

Circuit-connecting material 16 was obtained in the same manner as Example 4, except that the amount of γ-isocyanatopropyltriethoxysilane used was 7.5 g.

### [Comparative Example 5]

Circuit-connecting material 17 was obtained in the same manner as Example 4, except that the amount of ketimine group-containing compound (A-2) used was 7.5 g.

Each of the circuit-connecting materials of Examples 1-12 and Comparative Examples 1-5 was then evaluated by measurement of the circuit connection resistance, measurement of the bonding strength and observation of the connection appearance, and the usable life was evaluated. Three circuit-connecting materials were used for each evaluation: an untreated product (circuit-connecting material A), a circuit-connecting material that had been placed and sealed in an aluminum bag and treated for 5 days in a thermostatic bath set to 40°C (circuit-connecting material B), and a circuit-connecting material that had been treated for 1 day in a high-temperature, high-humidity bath set to 30°C-70% RH (circuit-connecting material C). Comparison between circuit-connecting material A and circuit-connecting material B allows the effect of temperature on usable life to be determined. Comparison between circuit-connecting material A and circuit-connecting material C allows the effect of humidity on usable life to be determined.

### [Measurement of circuit connection resistance]

A flexible circuit board (FPC) was fabricated with a 2-layer structure comprising 500 copper circuits with a line width of 50 µm, a pitch of 100 µm and a thickness of 8 µm on a polyimide film (trade name: UPILEX by Ube Industries, Ltd., thickness: 25 µm).
Separately, there was fabricated a glass board comprising 500 chromium circuits with a line width of 50 µm, a pitch of 100 µm and a thickness of 0.4 µm on glass (trade name: #1737 by Coming, Inc.). Next, circuit-connecting material A, B or C was used for hot pressing between the FPC and glass board at 160°C, 3 MPa for 10 seconds for connection across a width of 2 mm to obtain a connection structure, and the connection resistance was measured. The results are shown in Table 1.
The connection resistance using circuit-connecting material A was satisfactory connection resistance of about 1 Ω for all of Examples 1-12 and Comparative Examples 1-5. In Comparative Example 4, however, the connection resistance using circuit-connecting material B was over twice the connection resistance using circuit-connecting material A. In Comparative Example 5, the connection resistance using circuit-connecting material C was over twice the connection resistance using circuit-connecting material A.

### [Measurement of bonding strength]

After connecting circuits in the manner described above, the bonding strength was measured under conditions with 90°C peeling and a 50 mm/min peel rate. The results are shown in Table 1. In Examples 1-12 and Comparative Examples 1-5, the bonding strength was also satisfactory at 7 N/cm or greater when using any of circuit-connecting materials A, B or C.

### [Observation of connection appearance]

After connecting circuits in the manner described above, the connection structure was subjected to 250 h treatment under high-temperature, high-humidity conditions of 85°C/85% RH, and the appearance after treatment was observed with a microscope from the glass board side. Since the insulating property between electrodes is drastically reduced when peeling occurs in the interfacial space between a circuit-connecting material and electrode, such peeling was judged as NG. The results are shown in Table 1.
In Examples 1-12, the appearance was satisfactory when using any of circuit-connecting materials A, B and C. In Comparative Example 1, on the other hand, peeling occurred with all circuit-connecting materials A, B and C, resulting in NG evaluations. In Comparative Example 2, peeling occurred when using circuit-connecting material C, resulting in an NG evaluation. In Comparative Example 3, peeling occurred when using circuit-connecting material B, resulting in an NG evaluation.

**[Table 1]**

| Examined properties | Circuit-connecting material A (Initial characteristics) | | | | Circuit-connecting material B (Characteristics after 40°C, 5-day treatment) | | | | Circuit-connecting material C (Characteristics after open standing for 1 day at 30°C, 70%RH)) | | | |
|---|---|---|---|---|---|---|---|---|---|---|---|---|
| | Connection resistance (Ω) | Bonding strength (N/cm) | Connection appearance | | Connection resistance (Ω) | Bonding strength (N/cm) | Connection appearance | | Connection resistance (Ω) | Bonding strength (N/cm) | Connection appearance | |
| | | | Initial | After high-temperature, high-humidity treatment | | | Initiall | After high-temperature, high-humidity treatment | | | Initial | After high-temperature, high-humidity treatment |
| Examples 1 | 1.1 | 9.2 | Good | Good | 1.1 | 9.3 | Good | Good | 1.1 | 8.9 | Good | Good |
| Example 2 | 1.1 | 9.5 | Good | Good | 1.2 | 9.7 | Good | Good | 1.2 | 9.2 | Good | Good |
| Example 3 | 1.1 | 9.6 | Good | Good | 1.1 | 9.5 | Good | Good | 1.1 | 9.4 | Good | Good |
| Example 4 | 1.1 | 8.9 | Good | Good | 1.1 | 8.6 | Good | Good | 1.1 | 9.2 | Good | Good |
| Examples 5 | 1.1 | 9.8 | Good | Good | 1.2 | 9.9 | Good | Good | 1.2 | 9.9 | Good | Good |
| Example 6 | 1.1 | 8.9 | Good | Good | 1.1 | 10 | Good | Good | 1.4 | 10.3 | Good | Good |
| Example 7 | 1.2 | 9.1 | Good | Good | 1.2 | 8.3 | Good | Good | 1.2 | 9.4 | Good | Good |
| Examples 8 | 1.2 | 9.4 | Good | Good | 1.1 | 11.4 | Good | Good | 1.1 | 9.5 | Good | Good |
| Example 9 | 1.2 | 9.2 | Good | Good | 1.3 | 10.3 | Good | Good | 1.3 | 9.9 | Good | Good |
| Example 10 | 1.3 | 9.4 | Good | Good | 1.3 | 9.5 | Good | Good | 1.2 | 9.7 | Good | Good |
| Example 11 | 1 | 8.7 | Good | Good | 1.1 | 10.2 | Good | Good | 1.2 | 9.6 | Good | Good |
| Example 12 | 1.1 | 10.3 | Good | Good | 1.2 | 10.3 | Good | Good | 1.3 | 9.9 | Good | Good |
| Comp. Ex. 1 | 1.1 | 8.6 | Good | NG (peeling) | 1.1 | 8.4 | Good | NG (peeling) | 1.1 | 8.4 | Good | NG (peeling) |
| Comp. Ex. 2 | 1.1 | 9.1 | Good | Good | 1.1 | 8.6 | Good | Good | 1.1 | 9.2 | Good | NG (peeling) |
| Comp. Ex. 3 | 1.1 | 9.3 | Good | Good | 1.2 | 9.3 | Good | NG (peeling) | 1.2 | 9.4 | Good | Good |
| Camp. Ex. 4 | 1.4 | 9.8 | Good | Good | 4.5 | 10.2 | Good | Good | 1.5 | 9.7 | Good | Good |
| Comp. Ex. 5 | 1.4 | 9.8 | Good | Good | 1.4 | 10.2 | Good | Good | 5.6 | 9.4 | Good | Good |

## Claims

1. A circuit-connecting material for connection between a first circuit member having a first circuit electrode formed on the main side of a first board, and a second circuit member having a second circuit electrode formed on the main side of a second board, with the first circuit electrode and the second circuit electrode laid facing each other, the circuit-connecting material comprising a film-forming material, a curing agent that generates free radicals upon heating, a radical-polymerizing substance, an isocyanate group-containing compound and a ketimine group-containing compound represented by the following general formula (I),
wherein the isocyanate group-containing compound content is 0.1-5 parts by weight and the ketimine group-containing compound content is 0.1-5 parts by weight with respect to 100 parts by weight as the total of the film-forming material and the radical-polymerizing substance. 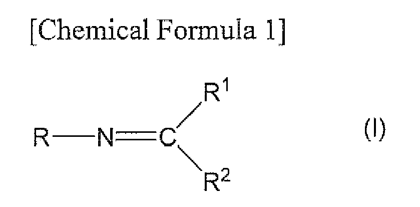 Wherein R represents an organic group, R¹ and R² each represent a C1-C4 monovalent aliphatic hydrocarbon group, and R¹ and R² may be linked together to form a cycloalkyl group.

2. The circuit-connecting material according to claim 1, further comprising an organic compound having a fluorine atom in the molecule.

3. The circuit-connecting material according to claim 1 or 2, further comprising an organic compound having a urethane group in the molecule and having a molecular weight of 10,000 or greater.

4. The circuit-connecting material according to any one of claims 1 to 3, further comprising conductive particles.

5. The circuit terminal connection structure comprising :
a first circuit member having a first circuit electrode formed on the main side of a first board and
a second circuit member having a second circuit electrode formed on the main side of a second board;
wherein the first circuit electrode and the second circuit electrode are electrically connected by arranging the first circuit electrode and the second circuit electrode to face with each other, situating a circuit-connecting material according to any one of claims 1 to 4 between the first circuit electrode and the second circuit electrode, and hot pressing in that state.

6. The circuit terminal connection structure according to claim 5, wherein the surface of either or both the first circuit electrode and the second circuit electrode is composed of at least one selected from among gold, silver, tin, platinum group and indium-tin oxide.

7. The circuit terminal connection structure according to claim 5 or 6, wherein either or both the first board and the second board are composed of at least one selected from among organic insulating materials and glass.

8. The circuit terminal connection structure according to any one of claims 5 to 7, wherein the surface of either or both the first circuit member and the second circuit member is subjected to coating or adhesion treatment with at least one selected from among silicon nitride, silicone compounds and polyimide resins.
